# EUROPEAN PATENT APPLICATION

(11) **EP 4 804 409 A1**
(43) Date of publication of application: **09.09.2026**
(21) Application number: 25161992.0
(22) Date of filing: 06.03.2025
(51) Int. Cl.: H03M 1/46

(54) **SAR-ADC**

(71) Applicant: Photeon Technologies GmbH, 6850 Dornbirn (AT)
(72) Inventor: Quartieri, Emanuele, 6850 Dornbirn (AT); Marcato, Francesco, 6850 Dornbirn (AT)
(74) Representative: Gangl, Markus

(57) **Abstract**

A successive-approximation-register analog-to-digital converter (SAR-ADC), comprising at least wherein the control logic is configured to access an N-bit register in N consecutive clock cycles to apply a successive-approximation-register algorithm based on a signal provided by the output of the comparator, and the application of the successive-approximation-register algorithm comprises, in each of the N consecutive clock cycles, that the control logic sets two bits which are next to each other by using two N-control-bits as follows:
- using the first N-control-bits, starting with the most-significant-bit which is initially set to a pre-defined value and proceeding to the least-significant-bit with each following clock cycle, leaves the set bit at the pre-defined value or flips the bit in dependence on the result of the comparator, and in the same clock cycle
- using the second N-control-bits, starting with the bit next to the most-significant-bit and proceeding to the least-significant-bit with each following clock-cycle, sets the bit next to the most-significant-bit to the pre-defined value.

## Description

The disclosure is in the field of electronic signal conversion, in particular of a successive-approximation-register (SAR) analog-to-digital converter (ADC). This particular type of converter is abbreviated as SAR-ADC.

An SAR-ADC is a specific type of ADC which converts a sample of an analog signal into a digital signal using an iterative binary search. The result is a digital code which gets more and more accurate which each iteration of the binary search. In order to be as fast as possible, each iteration is required to be done within one clock cycle of a system clock.

The typical components of a SAR-ADC are
- a clock input providing a clock cycle
- a signal input, being configured to receive an analog input signal and being connected to a track-hold-circuit
- a comparator, having two inputs and an output, one of the inputs being connected to the track-hold-circuit
- a digital-to-analog converter (DAC), having an input for a reference signal and an N-bit register, and being connected to one input of the comparator
- a control logic, being connected to
   ▪ receive the output of the comparator, and to
   ▪ control the DAC
- a signal output, being connected to the DAC to provide a digital output signal on basis of the analog input signal after completion of N clock cycles

The control logic is configured to access the N-bit register in N consecutive clock cycles to apply a successive-approximation-register algorithm based on the signal provided by the output of the comparator which comprises, in each of the N consecutive clock cycles, to apply a control signal to the N-bit register which, starting with the most-significant-bit which is initially set to a pre-defined value (for example 1) and to the least-significant-bit with each following clock cycle, leaves the set bit at the pre-defined value (for example 1) or flips the bit (for the example of the pre-defined value being 1 to flip the bit means to set it to 0) in dependence on the result of the comparator. The result of the comparator is the result of a comparison of the input V_{IN} provided by the track-hold-circuit and the input V_{DAC} provided by the DAC. It can be provided that a bit is flipped if the input provided by the DAC is larger than the input provided by the track-hold-circuit and that the pre-defined value remains at the pre-defined value if the input provided by the DAC is smaller than the input provided by the track-hold-circuit.

To each bit of the N-bit register a binary weight is assigned by the DAC, and the sum of the binary weights is the output signal of the SAR-ADC which, after completion of the iterative binary search algorithm, approximates the sample of the analogue signal. The more bits are used the more accurate the approximations become. In general, N bits are used in an N-bit register.

By way of example, in a 4-bit register the binary weights assigned to the bits (starting with the most-significant-bit) could be V_{REF}, ¾ V_{REF}, ½ V_{REF} and ¼ V_{REF}. In this example, the 4-bit register 0110 (with the leftmost bit being the most-significant-bit) equals an output value of 1,25 * V_{REF} (= 0 * V_{REF}+ 1 * ¾ V_{REF}+ 1 * ½ V_{REF} + 0 * ¼ V_{REF}).

It is a problem of known SAR-ADC that clock cycles must have a sufficient temporal length such that N-bit register perform as intended. This limits the lower end of a temporal duration of the clock cycles.

It is an object to provide a SAR-ADC and a method for converting an analog signal into a digital signal which work faster and/or more accurate.

This object is achieved by a SAR-ADC having the features of claim 1 and a method having the features of claim 3.

The disclosure achieves:
- a faster conversion time by optimizing unused clock phases
- better performance at high frequency
- an enhanced accuracy,
- the option of using a faster clock
- adaptability to different ADC resolutions (scalability)

In such a SAR-ADC, which comprises at least the typical components listed in paragraph 3, the control logic is configured to set two bits which are next to each other in the same clock cycle by using two N-control-bits.

In such a method, using an electronic device having a comparator and a DAC having an N-bit register, a SAR iterative binary search is used to obtain a digital representation of a sample of the analog signal in N bits, wherein, in N consecutive steps, the SAR algorithm is applied to the N bits of the N-bit register by using two N-control-bits and based on a signal provided by the output of the comparator which is the result of a comparison of the sample signal and an output of the DAC and the application of the SAR algorithm comprises applying, in each of the N consecutive steps:
- starting with the most-significant-bit which is initially set to a pre-defined value and proceeding to the least-significant-bit with each following clock cycle, the set bit is left at the pre-defined value or is flipped in dependence on the result of the comparator, and in the same step,
- starting with the bit next to the most-significant-bit and proceeding to the least-significant-bit with each step, the bit next to the most-significant-bit is set to the pre-defined value

As in previously known SAR-ADC, starting with the most-significant-bit which is initially set to a pre-defined value and proceeding in a direction to the least-significant-bit with each following clock cycle, the control unit leaves the set bit at the pre-defined value or flips the bit in dependence on the result of the comparator. For this operation the first of the two N-control-bits is used.

Contrary to previously known SAR-ADC, the control unit, starting with the bit next to the most-significant-bit and proceeding to the least-significant-bit with each following clock-cycle, sets the bit next to the most-significant-bit to the pre-defined value. For this operation the second of the two N-control-bits is used.

There are two types of delays which, in the prior art, limit the lower end of a temporal duration of the clock cycles.

The first type is caused by the time necessary for the functioning of the comparator (Comp_delay).

The second type is caused by the time necessary for the functioning of the DAC. The time available for the functioning of the DAC is being lengthened because the control unit, while evaluating a first bit, sets a second bit (which is the one next to the bit which is being evaluated) to the pre-defined value.

By setting the second bit next to the first bit (which is in the process of being evaluated) to the pre-defined value, while the first bit is still being evaluated there is more time available for the functioning of the DAC which allows for a faster operation of the SAR-ADC. It is possible to operate with a faster clock cycle (shortening of the period of each clock cycle).

An example for a pre-defined value of the bit is 1 (or HIGH). In this case, to flip a bit means to set the value to 0 (or LOW).

Preferred embodiments are defined in dependent claims.

In a preferred embodiment, the DAC is a known charge-scaling converter comprising an array of individually-switched capacitors, wherein each of the N bits is modelled by at least one capacitor and the binary weight assigned to each bit is given by the output voltage of the at least one capacitor which is determined by the capacity of each capacitor and the voltage applied to the capacitor during charging. In such a DAC, the main limitation is the settling time which is determined by the RC time constant of the switch resistance and the capacitor array. When the comparator performs the comparison, the input must be fully settled, otherwise errors may occur. By using a second N-control-bit for setting the bit next to the bit which is evaluated to the pre-defined value, there is more time available for the capacitors to charge.

In the standard SAR algorithm, the N-control-bits drive the capacitor array. For example, at a first rising of the edge of the clock signal, the most-significant-bit is set to the pre-defined value. The capacitor array has time to charge during the high phase of the clock signal and the comparator compares at the following edge. At the second rising edge of the clock signal, the output of the comparator is read, the corresponding bit is settled (i. e., left at the pre-defined value of flipped) and the algorithm continues. When high speed is required (e. g. a using a clock signal larger than about 100 MHz) the capacitor array might not have enough time to charge in the standard SAR algorithm. The time span after the comparator has switched, while the clock signal is low, is wasted time.

In the improved SAR algorithm of this disclosure two N-control-bits are used which allows the algorithm to go ahead while the clock is low. As soon as the comparator switches, the capacitor array starts to charge. During comparation phase the inputs of the comparator are disconnected.

In such an embodiment it can be provided that the capacitors are sized in powers of two.

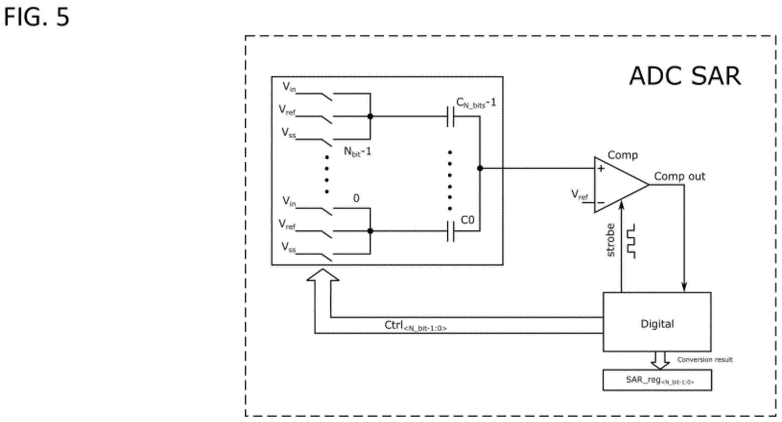

A preferred embodiment is discussed with respect to Figures 2 - 5. Figure 1 shows the prior art. As a non-limiting example, N = 10 bit and a pre-defined value of 1 are used.

In Figure 1 the standard SAR-ACD is depicted making use of a single 10-control-bit.

Figure 5 shows the successive-approximation-register analog-to-digital converter (denoted as ADC SAR) of the disclosure which uses two 10-control-bits.

The DAC is a charge-scaling converter comprising an array of individually-switched capacitors, wherein each of the N bits (bits 0 to N-1) is modelled by one capacitor (capacitors C0 to C_{N_bits} - 1). As is known in the art, each capacitor is coupled to a three-state-switch.

The control unit Digital provides two N-control-bits Ctrl_{<N_bit-1:0>} to the DAC.

The result of the DAC is delivered to the comparator Comp which also receives the analog input signal V_{ref}. The output of the Comparator Comp out is sent to the control unit Digital which, after completion of the method, gives the result in form of the digital signal SAR_reg_{<N_bit-1:0>}. The control unit acts on the DAC by using two N-control-bits Ctrl_{<N_bit-1:0>}. The whole system is provided with a clock signal strobe.

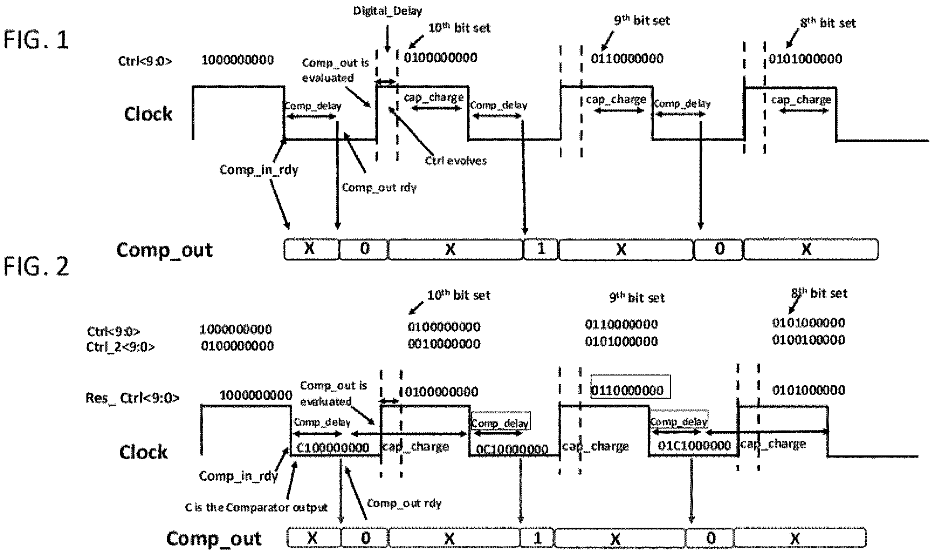

Figure 1 shows the standard SAR-ADC method using one 10-control-bit. In each clock cycle one bit is set to 1 and, in dependence on the result of the comparison, is left at 1 or flipped to 0. As there is a delay Comp_delay due to the functioning of the comparator time is lost.

In Figures 2 - 4 two 10-control-bits are used. The 10-bit DAC is a known charge-scaling converter comprising an array of individually-switched capacitors, wherein each of the 10 bits is modelled by one capacitor and the binary weight assigned to each bit is given by the output voltage of the capacitor. By using two 10-control-bits for setting the bit next to the bit which is evaluated to the pre-defined value, there is more time available for the capacitors to charge. When the comparator inputs are disconnected (clock = 0), Resulting Ctrl[9:0] advance by setting the next bit to 1, giving the capacitor array more time to settle the voltage for the comparator. This ensures that when the comparator performs the comparison, the inputs will be settled and ready.

At a first rising of the edge of the clock signal, the most-significant-bit is set to the pre-defined value. The capacitor array has time to charge during the high phase of the clock signal and the comparator compares at the following edge. At the second rising edge of the clock signal, the output of the comparator is read, the corresponding bit is settled (i. e., left at the pre-defined value of flipped) and the algorithm continues. As soon as the comparator switches, the capacitor array starts to charge. During comparation phase the inputs of the comparator are disconnected.

The Ctrl Bits logic can be composed by a MUX:

When clock is high the following formula is used: **Resulting Ctrl<9:0>** = **Ctrl<9:0>**

When clock is low the following formula is used: **Resulting Ctrl<9:0> = ((Ctrl<*9:0*> && Comparator output)**∥ **Ctrl_2<*9.0*>)**

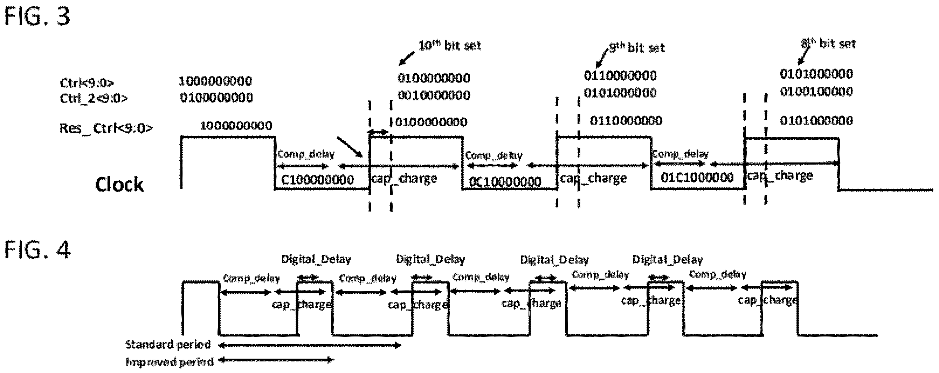

As a comparison of Figure 3 and 4 shows, it is possible to either provide the capacitors with a longer charging time (Figure 3) or to increase the clock frequency (Figure 4: improved period instead of standard period).

## Claims

1. A successive-approximation-register analog-to-digital converter (SAR-ADC), comprising at least:
- a clock input providing a clock cycle
- a signal input, being configured to receive an analog input signal and being connected to a track-hold-circuit
- a comparator, having two inputs and an output, one of the inputs being connected to the track-hold-circuit
- a digital-to-analog converter (DAC), having an input for a reference signal and an N-bit register, and being connected to one input of the comparator
- a control logic, being connected to
▪ receive the output of the comparator, and to
▪ control the digital-to-analog converter (DAC)
- a signal output, being connected to the digital-to-analog converter (DAC) to provide a digital output signal on basis of the analog input signal after completion of N clock cycles
wherein the control logic is configured to access the N-bit register in N consecutive clock cycles to apply a successive-approximation-register algorithm based on the signal provided by the output of the comparator, and the application of the successive-approximation-register algorithm comprises, in each of the N consecutive clock cycles, that the control logic sets two bits which are next to each other by using two N-control-bits as follows:
- using the first N-control-bits, starting with the most-significant-bit which is initially set to a pre-defined value and proceeding to the least-significant-bit with each following clock cycle, leaves the set bit at the pre-defined value or flips the bit in dependence on the result of the comparator, and in the same clock cycle
- using the second N-control-bits, starting with the bit next to the most-significant-bit and proceeding to the least-significant-bit with each following clock-cycle, sets the bit next to the most-significant-bit to the pre-defined value.

2. The converter of the preceding claim wherein the digital-to-analog converter is a charge-scaling converter comprising an array of individually-switched capacitors, wherein each of the N bits is modelled by at least one capacitor.

3. A method for converting an analog signal into a digital signal using an electronic device having a comparator and a digital-to-analog-converter having an N-bit register, wherein a successive-approximation-register iterative binary search is used to obtain a digital representation of a sample of the analog signal in N bits, wherein, in N consecutive steps, the successive-approximation-register algorithm is applied to the N bits of the N-bit register by using two N-control-bits and based on a signal provided by the output of the comparator which is the result of a comparison of the sample signal and an output of the digital-to-analog-converter and the application of the successive-approximation-register algorithm comprises applying, in each of the N consecutive steps by using the two N-control-bits:
- starting with the most-significant-bit which is initially set to a pre-defined value and proceeding to the least-significant-bit with each following clock cycle, the set bit is left at the pre-defined value or is flipped in dependence on the result of the comparator, and in the same step,
- starting with the bit next to the most-significant-bit and proceeding to the least-significant-bit with each step, the bit next to the most-significant-bit is set to the pre-defined value.

4. The method of the preceding claim wherein a charge-scaling converter comprising an array of individually-switched capacitors, wherein each of the N bits is modelled by at least one capacitor is used as the digital-to-analog converter.
